Europäisches Patentamt

European Patent Office

Office européen des brevets

(19)

(11) Veröffentlichungsnummer: **0 022 930**
**B1**

(12) **EUROPÄISCHE PATENTSCHRIFT**

(45) Veröffentlichungstag der Patentschrift: **13.06.84**

(21) Anmeldenummer: **80103389.5**

(22) Anmeldetag: **18.06.80**

(51) Int. Cl.³: **G 11 C 7/00, G 11 C 11/40, G 05 F 3/20**

(54) Nachladeschaltung für einen Halbleiterspeicher.

(30) Priorität: **20.07.79 DE 2929384**

(43) Veröffentlichungstag der Anmeldung:
**28.01.81 Patentblatt 81/4**

(45) Bekanntmachung des Hinweises auf die Patenterteilung:
**13.06.84 Patentblatt 84/24**

(84) Benannte Vertragsstaaten:
**AT DE FR GB NL SE**

(56) Entgegenhaltungen:
**EP - A - 0 011 700
EP - A - 0 013 302
US - A - 3 540 010
US - A - 3 789 243
US - A - 4 057 789
US - A - 4 070 656
US - A - 4 075 609
US - A - 4 090 255
US - A - 4 122 548
US - A - 4 156 941**

(73) Patentinhaber: **International Business Machines
Corporation
Old Orchard Road
Armonk, N.Y. 10504 (US)**

(72) Erfinder: **Heuber, Klaus
Taunustrasse 62
D-7030 Böblingen (DE)**
Erfinder: **Wiedmann, Siegfried, Dr.
Im Himmel 64A
D-7000 Stuttgart 80 (DE)**

(74) Vertreter: **Rudolph, Wolfgang
Schönaicher Strasse 220
D-7030 Böblingen (DE)**

(56) Entgegenhaltungen:
**IBM TECHNICAL DISCLOSURE BULLETIN, Band
13, Nr. 6, November 1970, New York, US, S.K.
WIEDMANN: "Restore circuitry for Bit/sense
system", Seiten 1705-1706
IEEE JOURNAL OF SOLID-STATE CIRCUITS,
Band SC-13, Nr. 5, Oktober 1978, New York, US,
K. KAWARADA et al.: "A fast 7.5 ns access 1 K-
Bit RAM for cachememory systems", Seiten
656-663**

Courier Press, Leamington Spa, England.

IBM TECHNICAL DISCLOSURE BULLETIN, Band 22, Nr. 10, Dezember 1980, New York, US, K. HEUBER et al.: "MTL storage array", Seiten 4606-4607
IBM TECHNICAL DISCLOSURE BULLETIN, Band 14, Nr. 6, November 1971, New York, US, R.D. MOORE et al.: "Monolithic memory restore circuit pair", Seiten 1687-1688

## Beschreibung

Die Erfindung betrifft eine Nachladeschaltung nach dem Oberbegriff des Patentanspruchs 1.

In den letzten Jahren hat auf dem Gebiet der logischen Verknüpfungsschaltungen und der integrierten Halbleiterspeichertechnik mit bipolaren Transistoren eine rege Entwicklung stattgefunden, die unter der Bezeichnung MTL (Merged Transistor Logic) oder auch I²L (Integrated Injection Logic) Eingang in die Fachliteratur gefunden hat. Es wird hierzu beispielsweise auf die Aufsätze im IEEE Journal of Solid State Circuits, Bd. SC/7, Nr. 5, Oktober 1972, Seiten 340 ff. und 346 ff., verwiesen. Außerdem sind Speicherzellen in MTL-Technik auch durch die US—PS 3 736 477 und die US—PS 3 816 758 bekanntgeworden.

Diese Halbleiterspeicher, deren Speicherzellen mit bipolaren Transistoren in MTL-Technik aufgebaut sind, zeichnen sich durch extrem kurze Schaltzeiten aus und eignen sich ganz besonders für extrem hochintegrierte Speicher und logische Schaltungsverbände. Die Bitleitungen von MTL-Speichern müssen nach einer Lese- oder Schreiboperation auf möglichst gleiches Spannungspotential innerhalb eines Adreßzyklus zurückgeführt werden, wozu eine sog. Nachlade-Operation erforderlich ist. Zu diesem Zwecke wurden verschiedene Verfahren und Schaltungsanordnungen vorgeschlagen. So ist z.B. in der DE—PS 25 11 518 eine Lösung bekanntgeworden, die durch eine bestimmte Struktur der peripheren Schaltkreise und Schreib-/Lesephasen einerseits sowie der Nachlade- und Auffrisch-Phasen andererseits ohne Veränderung der Speicherzelle eine Verringerung der Zykluszeit bei kleinen Speicherzellströmen erreicht. Dies geschieht in erster Linie dadurch, daß die Bitleitungströme während der Selektionsphase, in der in die Speicherzellen geschrieben bzw. aus ihnen gelesen wird, extern gesteuert werden. Die während der Auffrisch-Phase auftretenden erhöhten Bitleitungsströme werden dazu benutzt, um die Zellenknotenpotentiale auf solche Potentiale zu bringen, bei denen eine Speicherzelle durch Lese-/Schreib-Operation benachbarter Speicherzellen nicht gestört wird.

Obwohl diese Lösung einen schnellen Halbleiterspeicher mit geringer Leistungsaufnahme ermöglicht, hat diese Lösung den Nachteil, daß der im selektierten Zustand in die Wortleitung fließende Strom noch zu groß ist und außerdem die Bitleitungspegel noch in einem solchen Bereich liegen, daß eine bitseitig halbselektierte Speicherzelle dann umgeschrieben werden kann, wenn ein Schreib- und Lesevorgang an einer defekten Speicherzelle innerhalb des Speichers stattfindet.

Es wurde deshalb in der DE—PS 2 657 561 eine weitere Nachladeschaltung bekannt, die dadurch charakterisiert ist, daß eine Ruhezustand-Referenzschaltung über eine Nachladesteuerleitung von einem getakteten Signal gesteuert wird, daß mit der Ruhezustand-Referenzschaltung eine Fehlerfall-Referenzschaltung verbunden ist und daß beide über eine Referenzleitung mit den Nachladeschaltungen verbunden sind, daß die Pegel der Spannungen auf den Bitleitungen im Ruhezustand durch den Strom bestimmt wird, der durch zwei Stromquellen fließt, die mit den Bitleitungen direkt verbunden sind und den als Schottky-Dioden ausgeführten Entkoppeldioden, die ein gemeinsamer Kathodenanschluß mit der Referenzleitung verbindet.

Obwohl hier bereits eine Nachlade-Referenzschaltung für den Ruhezustand und eine für den Fehlerfall angegeben ist, hat diese Schaltung jedoch den Nachteil, daß sie nicht für integrierte Speicher mit MTL-Speicherzellen verwendet werden kann, da bei derartigen Speichern ein zusätzliches Problem auftritt, wie nachfolgend beschrieben wird. Zum Auslesen der in einer MTL-Speicherzelle gespeicherten Information wird deren Wortleitungspotential um einige 100 mV abgesenkt und gleichzeitig wird durch jede der beiden vorhandenen Bitleitungen ein Lesestrom zugeführt. Da die Emitter-Basisspannungen der vorhandenen PNP-Transistoren aller unselektierten Speicherzellen um ca. 0,5 V kleiner sind als die Emitter-Basisspannung der selektierten Speicherzelle, fließt praktisch der gesamte Lesestrom in die selektierte Speicherzelle. Dadurch wird im wesentlichen bewirkt, daß die Emitter-Basisspannung des einen PNP-Transistors höher ist als die des anderen. Die Spannungsdifferenz wird im Lese-/Schreibverstärker angezeigt. Haben nun alle nichtselektierten Zellen n eine Null gespeichert, dann fließt trotz des praktisch abgeschalteten Injektorstroms ein Rückinjektionsstrom

$$IR \sim \frac{1}{2} IO \times n,$$

wobei IO der Ruheinjektionsstrom der Speicherzelle ist. Aufgrund der hohen Sperrschichtkapazität klingt dieser Rückinjektionsstrom nur sehr langsam ab. Damit dieser parasitäre Lesestrom keinen großen Einfluß auf den Lesevorgang hat, muß der Lesestrom der selektierten Zelle groß sein, gegenüber dem parasitäten Rückinjektionsstrom der unselektierten Zellen. Aus diesem Grund muß der Ruhestrom der Speicherzelle auf einen sehr kleinen Wert gehalten werden, der bei der derzeit verwendeten Technik ungefähr zwischen 10 und 100 nA liegt. Daraus ergibt sich zwar eine sehr kleine Speicherruheleistung, jedoch ergeben sich daraus große Schwierigkeiten für die Nachladeoperation. Denn um einerseits zu gewährleisten, daß die nichtselektierten Zellen bei einer Dauerselektion des Speicherchips genügend Strom erhalten, um die gespeicherte Information zu halten und andererseits zu kontrollieren, daß der Ruhestrom nicht den Lesevorgang stört, müßte eine extrem genaue Bitleitungs - Nachlade - Operation ausgeführt werden. Eine Übersteuerung, wie sonst üblich, ist hier nicht möglich.

Der Erfindung liegt deshalb die Aufgabe zugrunde, eine Nachladeschaltung zu schaffen, die das Erzeugen eines exakten Nachladetaktimpulses vermeidet und den Einfluß von Spannungsabfällen auf die Zellspannung, bedingt durch den großen Nachladestrom, verhindert, und zwar unabhängig vom gespeicherten Bitmuster in den Speicherzellen eines Zellverbandes.

Die erfindungsgemäße Lösung besteht im Kennzeichen des Patentanspruchs 1.

Weitere Merkmale der Lösung ergeben sich aus dem Kennzeichen des Patentanspruches 2.

Die Erfindung wird nun anhand eines in den Zeichnungen dargestellten Ausführungsbeispiels beschrieben.

Es zeigen:

Fig. 1 einen Auschnitt aus einem Speicherchip mit Speicherzellen und mit den für die Nachladeoperation erforderlichen Schaltungen,

Fig. 2 eine detaillierte Schaltung für die Nachlade-Schaltung und

Fig. 3 ein Diagramm für den zeitlichen Verlauf des Nachladestroms.

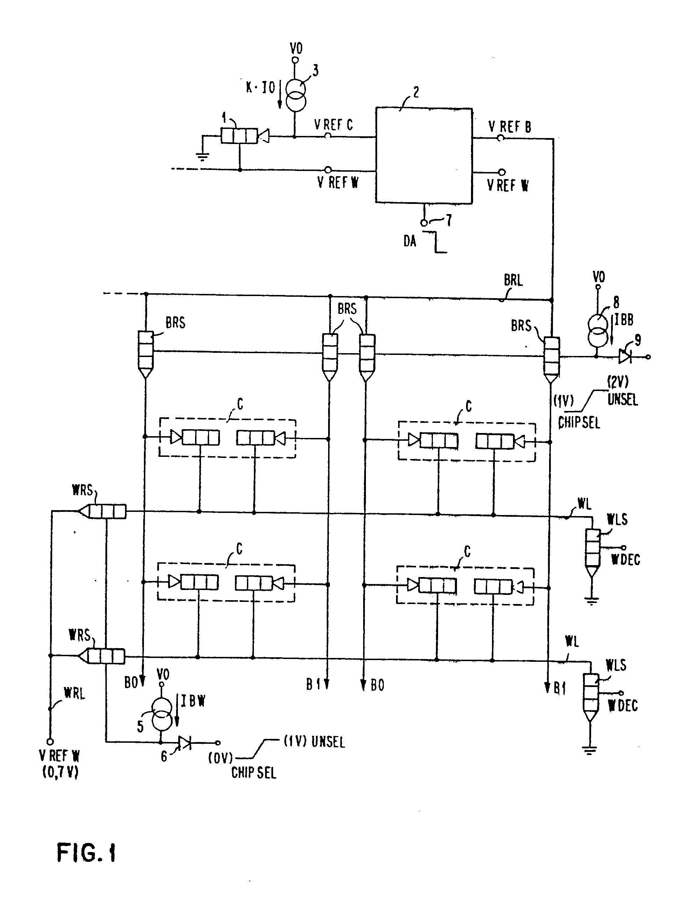

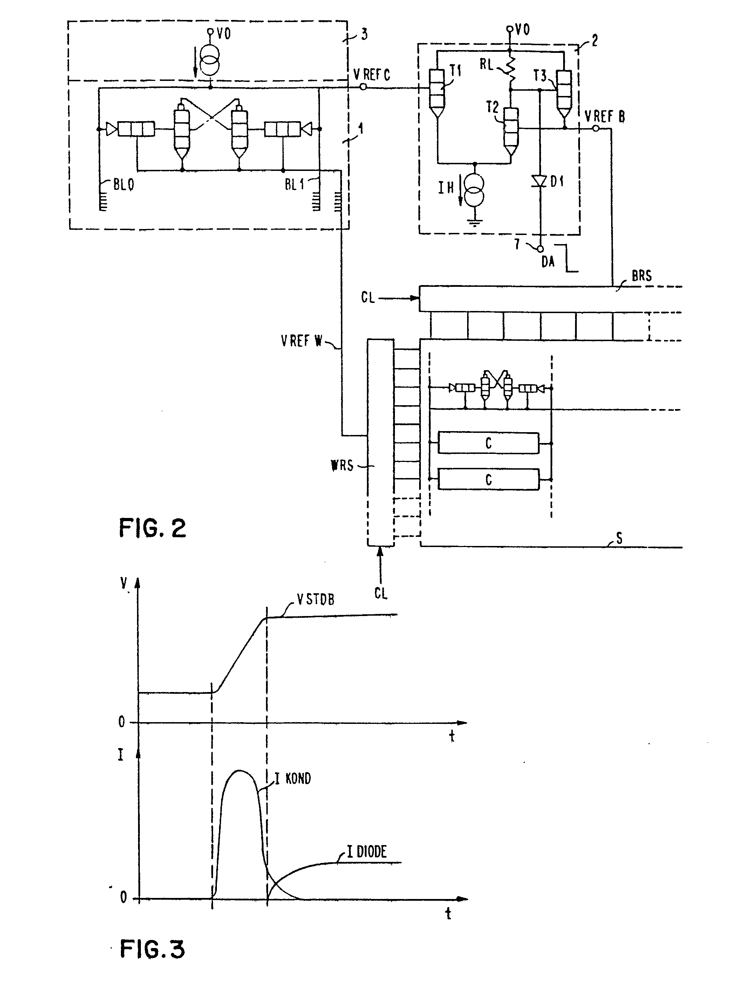

Bevor die Schaltungen nach den Fign. 1 und 2 detailliert beschrieben werden, soll zunächst das wesentliche der vorliegenden Erfindung erklärt werden.

Anstelle eines konstanten Nachladestroms wie bisher, wird bei den in den Fign. 1 und 2 dargestellten Schaltungen mit einer eingeprägten Spannungsquelle gearbeitet (sehr kleiner Innenwiderstand), deren Ausgangsspannung von einer Gruppe von Referenzspeicherzellen genau geregelt ist, und die die äquivalente Kapazität-Dioden-Last der Speichermatrix auf ihren stationären Wert auflädt. Die Spannungsquelle wird während der Chip-Selekt-Phase deaktiviert. Der Zellenruhestrom wird hier aus derselben Spannungsquelle geliefert wie der Nachladestrom. Es ist hier keinerlei Taktimpuls erforderlich, da sich der Nachladestrom automatisch und schnell auf den Zellenruhestrom einpendelt.

Dabei wird mit Hilfe also von Referenzspeicherzellen eine Zell-Referenzspannung erzeugt, von der die Ausgangsspannung abgeleitet wird. Dieses Schema bzw. dieses Schaltungsanordnung hat den Vorteil, daß anstelle eines konstanten Nachladestroms mit einer eingeprägten Spannungsquelle gearbeitet wird, die einen sehr kleinen Innenwiderstand aufweist und deren Ausgangsspannung von einer Gruppe von Referenzspeicherzellen so genau geregelt ist, daß die Kapazität-Dioden-Last der integrierten Speicherzellenmatrix auf ihren stationären Wert aufgeladen wird. Die Spannungsabfälle an Leitungen und Schaltern, hervorgerufen durch den Nachladestrom sind kurz vor dem Erreichen der stationären Zellspannung äußerst klein, wodurch sich eine genaue Regelung des Zellstroms ergibt. Aufgrund des hohen Nachladespitzenstroms ist eine sehr schnelle Nachladezeit möglich. Hinzu kommt, daß dies alles zusammen erreicht wird, obwohl der Schaltkreisaufwand zur Durchführung der Nachladeoperation äußerst gering ist und keine besonderen Toleranzforderungen bei der Herstellung erforderlich sind.

In Fig. 1 ist eine Speichermatrix schematisch gezeichnet, in der vier Speicherzellen C in MTL-Technik prinzipiell dargestellt sind. Die Speicherzellen C sind über Bitnachladeschalter BRS und die Bitleitungen B0 und B1 mit einer Bitreferenzleitung BRL sowie einer Stromquelle 8 für den Strom IBB sowie mit einer Diode 9 verbunden, an der das Chip-Selektionssignal CHIP SEL liegt. Mit der Bitreferenzleitung BRL sind k Referenzspeicherzellen über einen Impedanzwandler 2 verbunden. Die Referenzspeicherzellen sind schematisch durch den Transistor 1, der von einer Stromquelle 3 gespeist wird, dargestellt. Der Impedanzwandler 2 wird durch ein Signal DA am Eingang 7 während der Selektionsphase abgeschaltet, wie bereits beschrieben. Der Impedanzwandler 2 hat einen niederohmigen Ausgang, wodurch bewirkt wird, daß er an seinem Ausgang eine genaue Referenzspannung $VREFC = VREFB$ liefert. Sind die Spannungen über die Bitreferenzleitung BRL und über die Wortreferenzleitung WRL sowie über die Bitnachladeschalter BRS und über Wortnachladeschalter WRS an den Dioden der Speicherzellen C angelegt, dann stellt sich automatisch der Ruhestrom ein. Der Einschwingvorgang erfolgt mit maximal möglicher Geschwindigkeit, die durch die Ausgangsimpedanze des Impedanzwandlers 2 bestimmt wird.

Auf der Wortseite wird die Speichermatrix über die Diode 6, an deren Eingang das CHIP-SEL-Signal anliegt, und über eine Stromquelle 5 gesteuert, die beide mit der Basis der Wortnachladeschalter WRS verbunden sind. Die Wortnachladeschalter WRS sind mit ihrer Ausgangselektrode mit der Wortleitung WL verbunden und mit ihrem Emitter mit einer Wortreferenzspannungsleitung WRL. Das daran anliegende Potential VREFW ist identisch mit dem Potential VREFW, das am Ausgang des Ersatzschaltbildes für die Referenzspeicherzellen 1 anliegt. Auf der rechten Seite sind die Wortleitungen jeweils mit einem Wortleitungsschalter WLS abgeschlossen, dessen Emitter mit Masse verbunden ist und dessen Basis mit dem Ausgang eines nicht dargestellten Wortdecoders verbunden ist.

Aus dem Schaltbild nach Fig. 2 ist klar ersichtlich, daß die Referenzspeicherzellen 1 in ihrem Aufbau identisch mit dem der Speicherzellen C im eigentlichen Speicher ist, der rechts unten in der Fig. 2 schematisch dargestellt ist. Den Referenzspeicherzellen 1 ist eine Stromquelle 3 vorgeschaltet, die den Strom $k \times I0$ liefert, wobei der Faktor k gleich der Anzahl der

Referenzspeicherzellen 1 ist. IO ist dabei der Ruhestrom pro Zelle. Die Anzahl der Referenzspeicherzellen 1 kann dabei von einer Speicherzelle bis zu 20% der im eigentlichen Speicher angeordneten Speicherzellen C sein. Dies richtet sich nach der Größe des Arrays, dem Ruhestrom und der Auslegung des Impedanzwandlers 2.

Der Informationsspeicher ist sowohl wortseitig als auch bitseitig mit Restore-Schaltern WRS bzw. BRS ausgerüstet. Diese Restore-Schalter werden über die gezeigte Ansteuerleitung CL gesteuert und sind über die Wortreferenzleitung WRL mit den Referenzspeicherzellen 1 und über die Bitreferenzleitung BRL mit dem Ausgang des als Spannungsquelle dienenden Impedanzwandlers 2 verbunden. Der Eingang dieses Impedanzwandlers 2 ist mit den Referenzspeicherzellen 1 verbunden und außerdem besitzt er einen Steuereingang 7, an dem das Signal DA anliegt. Der Impedanzwandler 2 selbst besteht aus den Transistoren T1 und T2, die mit ihren Emittern miteinander und mit einer gemeinsamen Stromsenke für den Strom IH verbunden sind. Die Kollektoren der beiden Transistoren T1 und T2 liegen an einer Spannung VO, wobei zwischen dem Kollektor des Transistors T2 und dem Eingangspunkt für die Spannung VO noch ein Widerstand RL liegt. An dem Spannungspunkt VO liegt außerdem der Kollektor eines weiteren Transistors T3, der vom Ausgang des Transistors T2 und von dem Steuersignal DA über eine Diode D1 gesteuert werden kann. Der Emitter dieses Transistors T3 ist mit der Basis des Transistors T2 verbunden und bildet den Ausgang des Impedanzwandlers 2.

Im nachfolgenden soll nun die Funktionsweise der Schaltung beschrieben werden. Zunächst wird die Funktionsweise während der Ruhezustands-Phase beschrieben.

In diesem Fall sind die Bit- und Wortreferenzschalter BRS und WRS leitend, so daß durch jede Speicherzelle C der Ruhezustandsstrom fließt. Die Bit- und Wortreferenzschalter BRS und WRS sind quasi als ideale Schalter ausgeführt und haben eine sehr kleine Restspannung. Von der Stromquelle 3 oberhalb der Referenzspeicherzellen 1 wird für die Speicherzellen C aush der Ruhezustandsstrom geliefert. Die k Referenzspeicherzellen 1 geben an ihrem Ausgang die Zellreferenzspannung VREFC ab, wobei die Verstärkung durch den nachgeschalteten Impedanzwandler 2 erfolgt. Dieser Impedanzwandler ist hier als sog. Feedback-Schaltung ausgeführt. Es können selbstverständlich auch andere bekannte Schaltungen eingesetzt werden. Wenn am Steuereingang das Steuersignal DA unwirksam ist, dann ist die Eingangsspannung VREFC gleich der Ausgangsspannung des Impedanzwandlers 2, d.h. VREFB=VREFW=VREFC.

Im folgenden sei nun die Selektions-Phase beschrieben, während der das Steuersignal DA am Eingang des Impedanzwandlers 2 aktiv, d.h.

unten, ist. Das bedeutet, daß der als Referenzverstärker wirkende Impedanzwandler 2 abgeschaltet ist und Speicherzellen C im Imformationsspeicher 5 selektiert werden könne. Ohne diese Operation wäre nämlich die Bitleitungsentladung nicht möglich.

Nach dieser Selektions-Phase kann nun auf bekannte Art und Weise geschrieben oder gelesen werden.

Danach folgt die in nachfolgenden beschriebene Nachlade-Phase. Dabei kann davon ausgegangen werden, daß die Bitleitungen BL entladen sind, d.h., daß die Spannung an den Speicherzellen C innerhalb des Informationsspeichers S ca. 400 mV kleiner ist als die Spannung an den Referenzzellen 1. Da der Ruhezustandsstrom durch die Referenzzellen 1 fließt, fließt praktisch kein Strom durch die Speicherzellen C. Für den Nachladevorgang haben die Speicherzellen C die Charakteristik einer Schaltung bestehend aus einer Diode parallel zu einem Kondensator. Am Ende des Nachladevorgangs fließt durch die nachzuladende Speicherzelle C der Ruhezustandsstrom (I-Diode=I-Ruhezustand, I-Kondensator=0).

Durch die e-Funktion der Diodenkennlinie fließt I-Diode=I-Ruhezustand praktisch erst dann, wenn die Ruhezustandsspannung bis auf wenige mV erreicht ist.

Dadurch wird erreicht, daß der Nachladevorgang durch Anlegen einer eingeprägten Spannung an die entladenen Speicherzellen C erfolgt. Der Strom I-Kondensator wird durch die Spannungsquelle mit der maximalen Stromliefermöglichkeit erzeugt und die richtige Zellspannung stellt sich sehr schnell ein, wonach der Ruhezustandsstrom fließt. Bei schnellem Nachladevorgang gilt:

I-Kondensator:I-Diode
20:1

Je kleiner der Ruhestrom ist und je größer das Array, um so größer wird das Verhältnis:

I-Kondensator>>I-Diode

In Fig. 3 ist der Verlauf der Zellspannung beim Nachladevorgang gezeigt. Außerdem ist dem unteren Teil dieses Diagramms der Verlauf des Stromes I-Kondensator und des Stromes I-Diode gezeigt.

Wie aus dem oberen Teil des Diagramms hervorgeht, verläuft die Zellspannung bedingt durch die Ausführung des Impedanzwandlers 2 so, daß nach der Selektierung ein relativ steiles Ansteigen auf die Ruhezustandsspannung der Speicherzelle erfolgt, und zwar weist die Kurve einen relativ scharfen Knick im oberen Teil der Spannungskurve auf.

Nach Fig. 3 ist der Verlauf des Stromes I-Kondensator und des Stromes I-Diode gezeigt. Wie bereits ausgeführt, ist der maximale I KOND durch die Stromliefermöglichkeit des Impedanzwandlers bestimmt, was andererseits den maximalen Spannungsanstieg ergibt. Durch die Charakteristik des Impedanzwandlers steigt die Spannung rasch bis nahe an den Endwert und geht mit einem scharfen Knick auf den statischen Wert über. Dadurch setzt ein Strom I-Diode frühzeitig ein und steigt rasch auf den Ruhewert an.

Obwohl das beschriebene Ausführungsbeispiel mit Referenzspeicherzellen 1 und Informationsspeicherzellen in MTL-Technik beschrieben ist, können selbstverständlich auch andere Speicher mit bipolaren Transistoren verwendet werden, deren Zellen als Lastelemente hochohmige Widerstände oder NPN-Transistoren verwenden.

Durch diese Schaltung mit Spannungseinprägung entsteht also zu Beginn der Nachlade-Phase ein sehr großer Spitzenstrom, der die Speicherzellkapazitäten sehr schnell hochlädt. Dieser Spitzenstrom klingt jedoch auch sehr rasch wieder ab, so daß er kurz vor Erreichen der stationären Zellspannung nur noch einen sehr kleinen Wert hat, wodurch die Zellspannung sich sehr genau einregelt. Daraus ergibt sich, daß keine besonderen Zeitsteuerimpulse für die Steuerung des Nachladestroms erforderlich ist und der Schaltkreisaufwand gering ist. Außerdem sind die Spannungsabfälle, die an Leitungen und Schaltern durch den Nachladestrom hervorgerufen werden, äußerst klein, so daß das Einpegeln auf die stationäre Zellspannung nicht nachteilig beeinflußt wird. Die Zeit für den Nachladevorgang ist durch das Auftreten des hohen Spitzenstroms äußerst gering, so daß sich die Zugriffszeit bei einem Speicher der vorgenannten Art mit Hilfe der beschriebenen Schaltung wesentlich verkürzen läßt.

## Patentansprüche

1. Nachladeschaltung für einen integrierten Halbleiterspeicher, dessen Speicherzellen aus bipolaren Transistoren mit Lastelementen bestehen, die in Kreuzungspunkten von Wortleitungen und Bitleitungspaaren liegen, die über Bit- und Wortreferenzleitungen sowie Bitnachlade- und Wort-Nachlade-Schalter die erforderlichen Spannungen zur Aufrechterhaltung der gespeicherten Information liefert, dadurch gekennzeichnet, daß alle Zellen des Speichers im Ruhezustand einen Ruhezustandstrom erhalten, indem vorgeschaltete Referenzspeicherzellen über einen als Spannungsquelle mit sehr kleinem Innenwiderstand dienenden Impedanzwandler (2) eine Referenzspannung über die genannten Referenzleitungen (BRL, WRL) an die Speicherzellen abgeben, daß an einem Steuereingang (7) des Impedanzwandlers ein Steuersignal (DA) anliegt, das den Impedanzwandler während einer Chip-Selektions-Phase deaktiviert, und daß beim Nachladen ein maximaler Strom durch die Spannungsquelle erzeugt und den Speicherzellen zugeführt wird, der beim Erreichen der von den Referenzzellen gelieferten Referenzspannung an den genannten Referenzleitungen sofort auf den Wert absinkt, der für den Ruhezustand erforderlich ist, wobei die Umsteuerung vom Nachladezustand in den Ruhezustand nur vom Erreichen des Wertes der Ruhezustandsspannung gesteuert wird.

2. Nachladeschaltung nach Anspruch 1, dadurch gekennzeichnet, daß die Gruppe vorgeschalteter Referenzspeicherzellen (1) n Speicherzellen umfaßt, wobei n=1 oder bis 1/5 der aud den Speicherchip vorhandenen Informations-Speicherzellen (C) ist.

## Claims

1. A restore circuit for an integrated semiconductor storage, the storage cells of which consist of bipolar transistors with load elements at the cross-points of word lines and bit line pairs, comprising bit and word reference lines as well as bit restore and word restore switches supplying the voltage required for maintaining the stored information, characterized in that in the standby state, all cells of said storage receive a standby current in that connected reference storage cells, through an impedance converter (2) acting as a voltage source with a very low internal resistance, supply a reference voltage on said reference lines (BRL, WRL) to said storage cells, that a control signal (DA), deactivating said impedance converter during a chip selection phase, is applied to a control input (7) of said impedance converter, and that during the restore operation, a maximum current is produced by said voltage source and fed to said storage cells, which, having reached the magnitude of the reference voltage supplied by said reference cells on said reference line, immediately drops to the value required for the standby state, control from the restore to the standby state being solely a function of the value of the standby voltage having been reached.

2. A restore circuit according to claim 1, characterized in that the group of connected reference storage cells (1) comprises n storage cells, wherein n=1 or up to 1/5 of the information storage cells (C) present on the storage chip.

## Revendications

1. Circuit de rechargement pour une mémoire à semiconducteurs dont les cellules à mémoire sont constituées par des transistors bipolaires comportant des éléments de charge disposés aux points de croisement des lignes de mot avec des paires de lignes de bit, ledit circuit de rechargement fournissant à travers des lignes de référence de bit et de mot et au moyen de commutateurs de recharge de bit et de mot les tensions nécessaires pour conserver les informations stockées, caractérisée en ce qu'un courant de repos est appliqué à toutes les cellules de la microplaquette de mémoire à l'état de repos, des cellules à mémoire de référence montées en amont délivrant aux cellules de mémoire une tension de référence à travers un convertisseur d'impédance (2) à impédance interne faible faisant fonction de source de tension via lesdites lignes de référence (BRL, WRL), en ce qu'un signal de commande (DA) est appliqué à une entrée de commande (7) dudit convertisseur d'impédance, lequel signal de commande rend inactif ledit convertisseur d'impédance au cours d'une phase de sélection de la microplaquette, en ce qu'un courant maximal est généré par la source de tension lors du rechargement et qu'il est injecté dans lesdites cellules à mémoire, lequel courant maximal est, lorsque qu'il atteint la tension de référence fournie par les cellules de référence auxdites lignes de référence, réduit immédiatement à la valeur requise pour l'état de repos, le passage de l'état de rechargement à l'état de repos est commandé seulement quand la tension de repos atteint ladite valeur.

2. Circuit de rechargement selon la revendication 1, caractérisé en ce que le groupe formé par lesdites cellules de référence en amont (1) comprend n cellules à mémoire, où n est égale à 1 ou au maximum à 1/5 fois le nombre des cellules à mémoire d'information (C) contenues dans ladite microplaquette de mémoire.

FIG. 1

FIG. 2

FIG. 3